Europäisches Patentamt

European Patent Office

Office européen des brevets

(19)

(11) Publication number: **0 225 111**
A2

# (12) EUROPEAN PATENT APPLICATION

(21) Application number: 86308991.8

(22) Date of filing: 18.11.86

(51) Int. Cl.⁴: **C 30 B 31/14**
C 30 B 25/12

(30) Priority: 18.11.85 US 799233

(43) Date of publication of application:
10.06.87 Bulletin 87/24

(84) Designated Contracting States:
AT BE CH DE ES FR GB GR IT LI LU NL SE

(71) Applicant: ANICON, INC.
2240 Ringwood Avenue
San Jose California 95131(US)

(72) Inventor: Seilheimer, Richard A.
420 Pine Hill Lane
Pleasanton California 94566(US)

(72) Inventor: Macklin, Ronald J.
1225 Ravenscourt Avenue
San Jose California 95128(US)

(72) Inventor: Brooks, Carl S.
3076 Kennedy Avenue
Livermore California 94550(US)

(74) Representative: Armitage, Ian Michael et al,
MEWBURN ELLIS & CO. 2/3 Cursitor Street
London EC4A 1BQ(GB)

(54) Wafer boat manufacture and product.

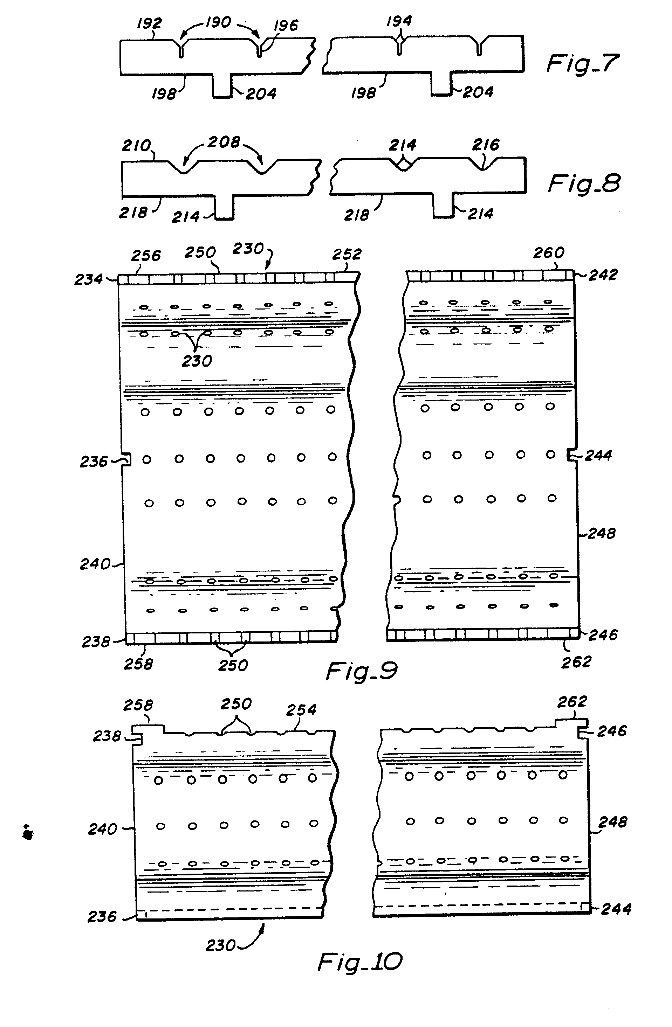

(57) High precision chemical vapor deposition wafer boats are constructed from hemicylinders (110), wafer support rails (Figures 7, 8) and semicircular end closures (170). The end closures have tabs (174-178) which engage slots (114, 122-128 etc.) in the hemicylinder, and the rails have tabs (204, 214) which engage slots and/or rectangular holes (146, 148, 158, 160) in the hemicylinder wall. The engaging elements are cut with high precision, preferably with a laser, to provide a distance between the opposing surfaces of engaged elements of less than 0.6 mm. The assembled components are joined by welding the engaged elements (tabs with holes or slots) into a unitary structure without raising the temperature of the remainder of the elements being joined to a distorting temperature.

Fig.4

Fig.6

Fig.7

Fig.8

EP 0 225 111 A2

## WAFER BOAT MANUFACTURE AND PRODUCT

This invention relates to the manufacture of quartz accessories used in the coating of semiconductor wafers in chemical vapor deposition devices. In particular, this invention relates to the manufacture and assembly of precision quartz articles which meet the requirements of advanced CVD vapor deposition boats and similar complex quartz articles, and the products produced thereby.

A variety of devices have been used to load semiconductor wafers into treatment devices, position them during treatment and remove them from treatment devices. These semiconductor wafer "boats" are preferably made of high purity quartz to minimize the contaminants introduced into the treatment devices with the wafers and to take advantage of the higher operating temperatures available using quartz. As more advanced coating methods were developed, simultaneous coating of batches of semiconductor wafers became customary, and boats were developed which could support many wafers in a position oriented for most effective coating. Examples of these boats are described in U.S.Patents 3,660,179 and 4,466,381, for example. U.S.Patent 4,098,923 discloses a stainless steel boat comprising two hemicylinders with closed ends and slotted rails for coating semiconductor wafers with silicon dioxide by CVD processes in a tube furnace.

Most recently, vertical chemical vapor deposition devices have been developed with the capability of routinely coating batches of semiconductor wafers with coatings having an edge-to-center and wafer-to-wafer variation in coating thickness of plus or minus one percent and less. With this equipment, the rejection rate of VLSI chips was reduced to levels permitting their routine commercial manufacture.

The higher levels of coating uniformities have been achieved, in part, by controlling variables in all parts of the process, and in particular controlling the movement of reaction gases in the vicinity of wafers. In some processes, increased control has been achieved by enclosing the wafers in closed wafer boats which have passageways which permit gas diffusion into the boats and prevent direct impingement of turbulent gas streams on the wafers. Boats made of high purity quartz, comprising upper and lower hemicylinders with open and closed ends, and with slotted wafer support rails disclosed in US 4582020 (EP 161101) and US 4548159 (EP 167374).

Quartz glassware for CVD systems is manufactured by glass blowers, that is, glass craftsmen who have been trained in glass shaping and fabrication. Quartz glass, being pure, differs from most glass mixtures in melting characteristics. At very high temperatures at which it can be shaped or welded, it flows or "slumps", and each glass article thus has dimensions which differ from others made by an identical process. Dimensional tolerances required for CVD boats which are suitable for the vertical CVD reactors can be achieved only by close inspection and the rejection of a majority of boats, even when manufactured with the greatest level of skill and care.

Boats have been heretofore manufactured by cutting glass pieces from larger stock and welding the assembled pieces with a gas flame, in much the same manner as steel plate is joined by welding to make a boiler. Adjacent portions of the glass pieces are melted and supplemented with melted quartz from a rod. Unfortunately, the areas adjacent to the weld begin to flow, and distortion of the pieces results. Complex fixtures used to position the pieces in the precisely dimensioned relationships desired in the final product expand and contract due to thermal expansion during the welding process, further frustrating efforts to achieve the desired precision. Distances between the boat surfaces and wafers, and between adjacent wafers mounted within the boats thus tend to vary beyond tolerable limits. The gas diffusion patterns within a boat during a coating process are extremely sensitive to the shape and size of these distances.

The object of this invention is to provide a method for manufacturing and fabricating wafer boats from prefabricated pieces which are made with a higher level of original precision and have new shapes and configurations which facilitate their assembly and joining with simplified fixtures. These advances have been obtained by refinement of the manufacturing methods, including the application of laser cutting techniques which make available more precise and more suitable joining surfaces.

The high precision chemical vapor deposition wafer boats of this invention are constructed from upper and lower hemicylinders, upper and lower end closure plates and wafer mounting rails. At least one of the hemicylinder and end closure plates has at least two substantially rectangular end plate mounting slots in the edge thereof, and the other of the hemicylinder and end closure plate has at least two end plate mounting tabs with substantially rectangular cross-sections. Each end plate mounting tab is positioned to engage one of said end plate mounting slots, and the end plate mounting slots and tabs are preferably dimensioned to provide a spacing of less than 0.6 mm between opposing surfaces when the tabs and slots are engaged.

The lower wafer boat hemicylinder component has rail mounting holes in the walls thereof, and the wafer support rails have substantially rectangular rail mounting tabs positioned for engaging said mounting holes. The rail mounting tabs and the rail mounting holes are preferably dimensioned to provide a spacing of less than 0.6 mm between opposing surfaces when the rail mounting tabs are placed in the rail mounting holes. The rail mounting holes can be either circular or rectangular in cross-section.

The kit of these components, the assembly of these components, and the welded assembly of the components are different aspects of this invention.

The process of this invention for manufacturing high precision wafer boats from quartz comprises the following steps. Substantially rectangular end plate mounting slots are laser cut in either the ends of hemicylinders or the edges of the end plates. Substantially rectangular rail mounting holes are laser cut in the wall of the lower hemicylinder. Substantially rectangular end plate mounting tabs are laser cut on the edges of the hemicylinder or end plate, depending upon which component has the end plate mounting slots. The hemicylinders, end closures and rails are assembled with the end plate mounting tabs engaging the end plate mounting slots and the rail mounting tabs engaging the rail mounting slots. Then the opposing edge surfaces of the end plate mounting slots and tabs and the rail mounting tabs and holes are welded. In the above process, the slots and holes are precision laser cut, and the distances between the opposing surfaces of the engaging tabs and slots and of the engaging tabs and holes are preferably less than 0.6 mm.

In the accompanying drawings:

Figure 1 is a side view of a fully assembled wafer boat.

Figure 2 is a cross-sectional view of a wafer boat taken along the line 2-2 in Figure 1.

Figure 3 is a fragmentary vertical cross-sectional view of a wafer boat containing wafers showing the relationship between the end closure plates and wafer support rails.

Figure 4 is a top view of a lower hemicylinder wall of one embodiment of a wafer boat according to this invention.

Figure 5 is a side view of the lower hemicylinder wall shown in Figure 4.

Figure 6 is a front view of an end closure plate suitable for the embodiment of the lower hemicylinder wall shown in Figure 4.

Figure 7 is a wafer support side rail.

Figure 8 is a wafer support bottom rail.

Figure 9 is top view of an inverted upper hemicylinder wall of one embodiment of a wafer boat according to this invention.

Figure 10 is a side view of the upper hemicylinder wall shown in Figure 9.

Figure 11 is a front view of an end closure plate suitable for the embodiment of the upper hemicylinder shown in Figure 9.

Figure 12 is an schematic view of an end closure plate and hemicylinder tab and slot assembly according to this invention before welding.

Figure 13 is a schematic view of a wafer support rail tab and rail mounting hole assembly according to the embodiment of the invention shown in Figures 4, 5, 7 and 8 before welding.

Figure 14 is a top view of a lower hemicylinder wall of another embodiment of a wafer boat according to this invention.

Figure 15 is a side view of the lower hemicylinder wall shown in Figure 14.

Figure 16 is a front view of an end closure plate suitable for the embodiment of the lower hemicylinder wall shown in Figure 14.

Figure 17 is a schematic view of a wafer support rail tab and rail mounting hole assembly according to the embodiment of the invention with the lower hemicylinder shown in Figures 14 and 15 before welding.

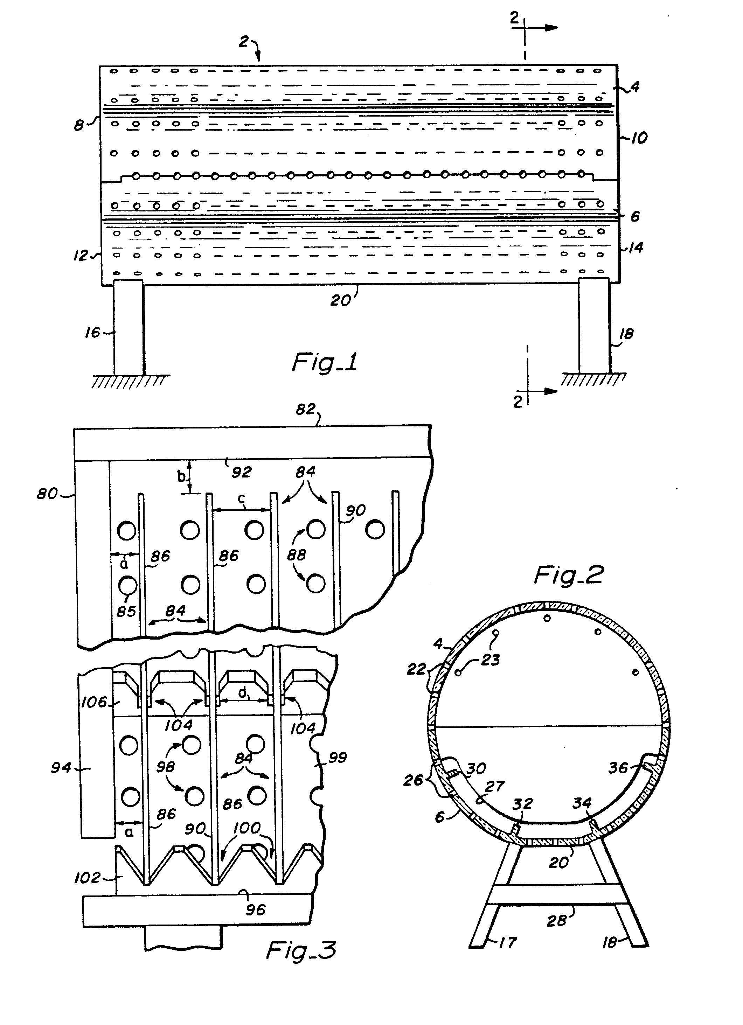

Figures 1-3 illustrate an example of a quartz wafer boat with which the manufacturing process and product of this invention are concerned. Figure 1 is a side view of a cylinderical wafer boat, and Figure 2 is a cross-sectional view taken along the line 2-2 in Figure 1. The central axis of the cylindrical wafer boat 2 is substantially horizontal, and the wafers are supported therein in an upright orientation for coating. The inner surfaces of the cylinder walls have the shape of and conform to the outer edges of the individual wafers being coated, being precisely spaced from the edges of the wafers. The cylindrical wafer boat 2 comprises an upper hemicylindrical section 4 and a lower hemicylindrical section 6 having mutually engaging opposed surfaces which join in a horizontal plane approximately through the central axis of the cylinder 2. The ends 8 and 10 of the upper hemicylinder 2 and ends 12 and 14 of the lower hemicylinder 6 are semicircular plates which are joined to the ends of the

hemicylinders by welds as is described in greater detail hereinafter. Leg projections 16 and 18 extend from the lower surface of hemicylinder 6 and are preferably integral therewith. The lower surface 20 of the hemicylinder 6 can be a flat section to conform to and accommodate the flat lower indexing edge typically present on a semiconductor wafer.

Referring to Figure 2, gas flow passageways 22 and 26 are provided in the walls of the hemicylinders, and gas flow passageways 23 are provided in the end plates 8 and 10 joined to the upper hemicylinder 4. The end plates 12 and 14 for the lower hemicylinder 6 have a recessed edge 27 which together with the end edge of the hemicylinder define a curved gas flow opening. Bottom rails 32 and 34 and side rails 30 and 36 are mounted on and joined to the inner wall surface of the lower hemicylinder 6 by welds as described hereinafter. Together, the rails support the wafers in an upright orientation, precisely spaced with respect to the end closure plates and to adjacent wafers to provide controlled gas flow to the wafer surfaces and precise coating. The support legs 17 and 18 are stabilized by horizontal element 28 welded thereto.

Figure 3 is a fragmentary cross-sectional view of a wafer boat with wafers loaded in a front-to-back position. The end plate 80 is precisely spaced from the wafers 84 at a distance "a" which is set for the particular wafer diameter to be coated and the coating process, and is selected to permit the desired gas flow between the surface of the first wafer and the end plates. The front surfaces 86 are the coating surfaces and are facing to the right in this representation. The inlet passageways 88 can be adjacent the back surfaces 90 of the wafers 84, and are precisely positioned to provide gas diffusion through the hemicylinder walls to the wafers. The precision and uniformity of the distance "b" between the outer edges of the wafers 84 and the inner surface 92 of the hemicylinder 82 is also critically important for coating uniformity.

The end plate 94 and inner surface 96 of the lower hemicylinder are correspondingly spaced (dimensions "a" and "b") from the outer edges of the wafers 84. The relationship between the gas flow passageways in the upper and lower hemicylinders and the positions of the wafers can be selected to provide the optimum coating uniformity for each process. In the embodiment shown in Figure 3, the gas inlet passageways 98 in the lower hemicylinder wall 99 can be positioned adjacent to the back surfaces 90 of the wafers and at a maximum distance from the front wafer surfaces 86. The wafers 84 rest in slots 100 in bottom rails 102 and are maintained in a predetermined wafer-to-wafer spacing by the slots 104 in the side rails 106. The wafer-to-wafer spacing "c" corresponds to the distance "d" between slots 104. To maintain the accuracy of this spacing, precise location of the slots in the lower rails is critical.

From the above, it is readily evident that any distortion of the end plates and rails which changes the present distances between the wafers and the wafer boat surfaces and between adjacent wafers leads to changes in gas flow and changes in coating thickness within a wafer and from wafer to wafer.

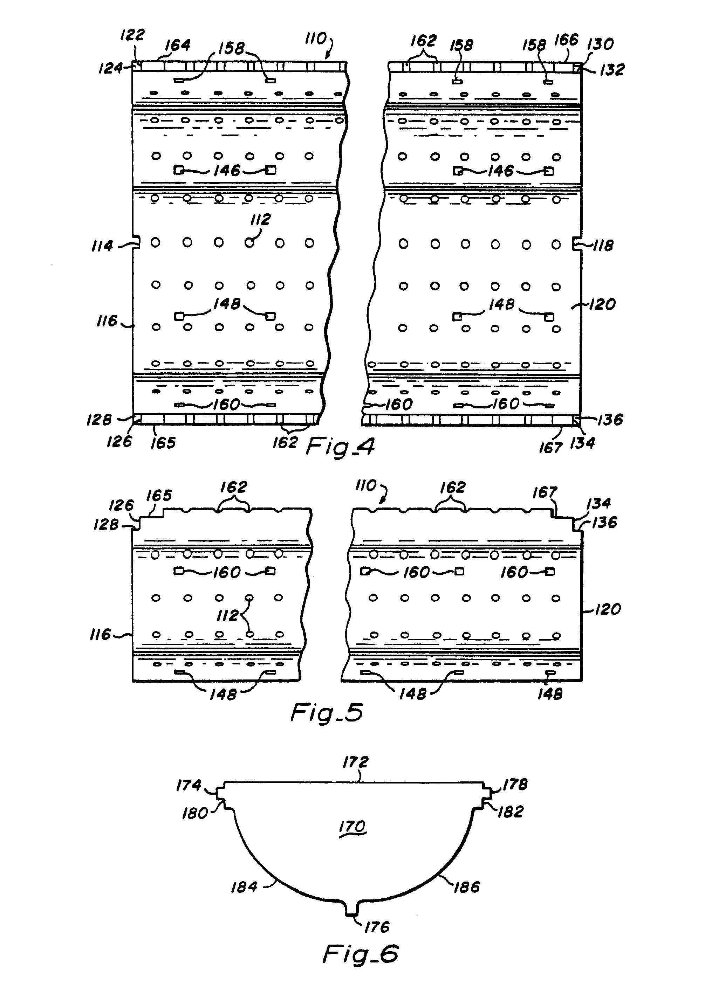

Figure 4 is a top view of a lower hemicylinder wall of a wafer boat according to one embodiment of this invention, and Figure 5 is a side view thereof. The lower hemicylinder wall 110 has rows of gas flow openings 112 in the walls, drilled or cut with precise dimensions and locations. Lower end plate mounting slot 114 is positioned along edge 116 of the hemicylinder 110, and lower end plate mounting slot 118 is positioned along edge 120 of the hemicylinder 110. Two sides of one upper end plate mounting slot are formed by adjoining edges 122 and 124 which intersect at a right angle adjacent one corner of edge 116, and two sides of a second opposite upper end plate mounting slot are formed by adjoining edges 126 and 128 which intersect at a right angle adjacent the opposite corner of edge 116. Two sides of an opposite upper end plate mounting slot are formed by adjoining edges 130 and 132 which intersect at a right angle adjacent one corner of edge 120, and two sides of a second opposite upper end plate mounting slot are formed by adjoining edges 134 and 136 which intersect at a right angle adjacent the opposite corner of edge 120.

Rail mounting holes are provided in the hemicylinder wall 110. In the embodiment shown in Figures 4 and 5, the rows of bottom rail mounting holes 146 and 148 and the rows of side rail mounting holes 158 and 160 are substantially rectangular holes. The term "rectangular", as used herein, is defined to identify a hole configuration as having a rectangular cross-sectional shape comprising parallel, opposing edges and corners with right angles, and includes all holes meeting this definition including squares wherein adjacent edges have the same length and holes wherein adjacent edges have different lengths. Since the hemicylinder walls are circular arcs in cross-section, the shapes of the edges in planes perpendicular to the axis of the hemicylinder are arcs of a circle.

The rows of semicircular arcs 162 in the upper edges of hemicylinder 110 form, together with opposed arcs in the upper hemicylinder (described in conjunction with Figures 9 and 10 hereinafter), form additional circular gas flow passageways.

Positioning notches 164 and 165 are provided at the ends of the edge 116 and positioning notches 166 and 167 are provided at the ends of the edge 120 to receive corresponding positioning tabs in the upper hemicylinder. These notches are precision cut to precisely engage and index the hemicylinders in a precise relationship.

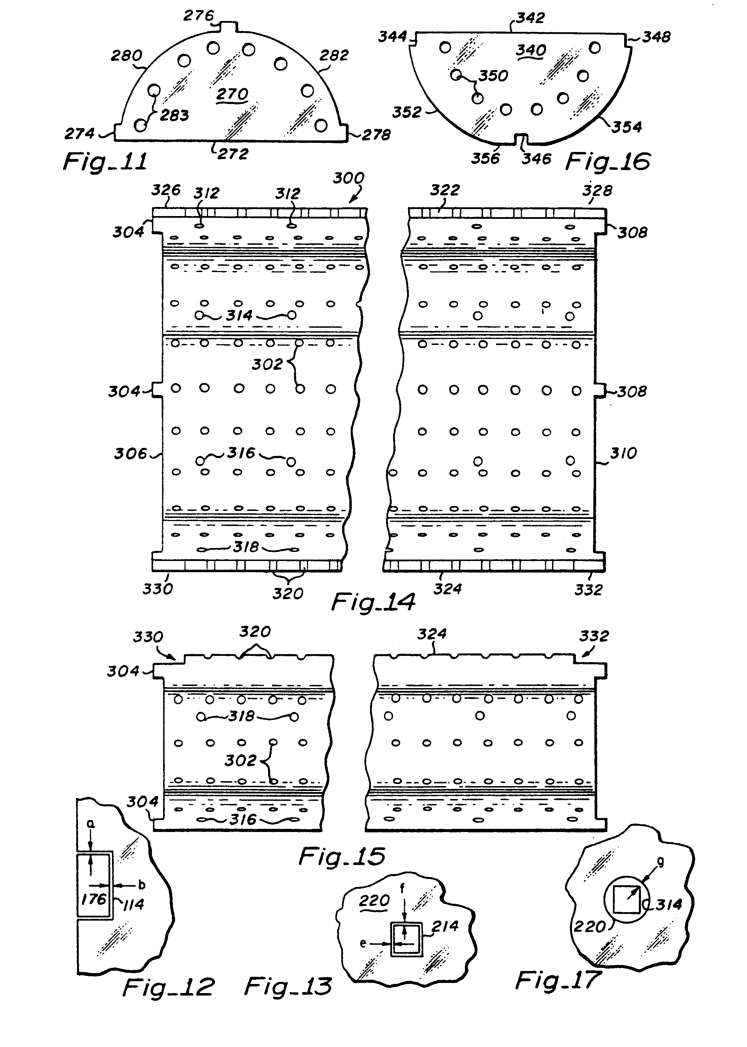

Figure 6 is a front view of an end closure plate for a lower hemicylinder of this invention. The end closure plate 170 is precision cut from quartz plate. It has a top edge 172 which abuts a corresponding straight edge of an end plate for the upper hemicylinder element (shown in Figure 11). Mounting tabs 174, 176 and 178 are precision cut to engage corresponding, respective mounting surfaces 122 and 124, slot 114 and surfaces 126 and 128 in edge 116 or mounting surfaces 130 and 132, slot 118 and mounting surfaces 134 and 136 in edge 120 of hemicylinder 110 in Figures 4 and 5. Edges 180 and 182 are precision cut to precisely conform to and engage the inner surface of the hemicylinder 110. Edges 184 and 186 are precision cut to maintain a distance from the inner surface of the hemicylinder 110 to provide an arcuate gas flow passageway such as the curved passageway shown in Figure 2 defined by edge 27 and the inner surface of the lower hemicylinder 6.

Figure 7 is a view of a wafer support side rail shaped according to this invention. The slots 190 in the upper edge 192 of the side rail have initial angular surfaces 194 which intersect to form an angle to guide placement of the wafer and a precision notch 196 having parallel opposing surfaces which are dimensioned to set and maintain the wafer in a precise orientation and position. The lower edge 198 is precision cut to conform to the inner surface of the lower hemicylinder 110 and has extending therefrom, a plurality of mounting tabs 204 which are precision cut to have a substantially rectangular cross-section to engage rail mounting holes 158 or 160 of the hemicylinder 110 (Figures 4 and 5).

Figure 8 is a view of a wafer support bottom rail shaped according to this invention. The slots 208 in the upper edge 210 of the bottom rail have angular surfaces 214 which intersect to form an angle to guide placement of the wafer and have a rounded bottom 216. The rounded bottom 216 precisely positions the wafers, automatically compensating for the variable wafer edge cross-sectional shapes resulting from the wafer polishing process. The lower edge 218 is precision cut to conform to the inner surface of the lower hemicylinder 110. Extending from the bottom edge 218 are a plurality of mounting tabs 214 which are precision cut to have a substantially rectangular cross-section to engage rail mounting holes 146 or 148 of the hemicylinder 110 (Figures 4 and 5).

The combination of the lower hemicylinder shown in Figures 4 and 5 and the rails shown in Figures 7 and 8 represent an optimum embodiment of this invention because of the precise fit of the rail mounting tabs 204 and 214 and the substantially rectangular rail mounting holes 146, 148, 158 and 160. This precise fit establishes and maintains precision alignment of the rails in the rail-hemicylinder assembly without the need for elaborate positioning jigs. However, careful welding and annealing is required to minimize and to relieve stress cracking which can occur in the hemicylinder walls due to differential thermal expansions of the rail tabs and the hemicylinder walls. In an alternate embodiment of this invention shown in Figures 14 and 15 described hereinbelow, round rail mounting holes are provided in the lower hemicylinder walls. Although this alternative embodiment requires the use of simple alignment jigs during welding, it presents less risk of introducing stress cracks around the mounting holes.

Figure 9 is a top view of an inverted upper hemicylinder wall and Figure 10 is a side view thereof. The upper hemicylinder wall 230 has gas flow openings 232 in the walls, drilled or cut with precise dimensions and locations. End plate mounting slots 234, 236 and 238 (slots 234 and 236 are hidden in Figure 9 by positioning tabs 256 and 258) are provided on edge 240. End plate mounting slots 242, 244 and 246 (slots 242 and 246 are hidden in Figure 9 by positioning tabs 260 and 262) are provided on the opposite edge 248 of hemicylinder 230. Semicircular arcs 250 in the upper edges 252 and 254, together with the corresponding arcs 162 of the lower hemicylinder 110 (Figures 4 and 5), form rows of additional circular gas flow passageways in the engaging surfaces of the upper and lower hemicylinders.

Positioning tabs 256 and 258 are provided at the ends of the edge 240 and positioning tabs 260 and 262 are provided at the ends of the edge 248. These are precision cut and positioned to engage the corresponding positioning notches 164, 165, 166 and 167 shown in Figures 4 and 5, precisely positioning the respective positions of the engaging hemicylinders.

Figure 11 is a front view of an end closure plate for an upper hemicylinder of this invention. The end closure plate 270 is precision cut from quartz plate. It has a bottom edge 272 which abuts a corresponding straight edge 172 of an end plate for the upper hemicylinder element (shown in Figure 6). Mounting tabs 274, 276 and 278 are precision cut to engage corresponding, respective mounting slots 234, 236 and 238 in edge 240 and mounting slots 242, 244 and 246 in edge 248 of the upper hemicylinder (Figures 9 and 10). Edges 280 and 282 are precision cut to precisely conform to the inner surface of the hemicylinder 110. Optional gas flow passageways 283 can be provided for boats used in processes requiring gas diffusion through the boat ends for optimum coating.

Figure 12 is a partial schematic view illustrating representative hemicylinder end plate mounting slot and end plate mounting tab assemblies before welding. The requirements for precision for the illustrated joints are representative of all of the joints in the wafer boat assemblage. End plate tab 176 and slot 114 are precision cut to provide a spacing between opposing walls "a" and "b" of preferably less than 0.6 mm and optimally less than 0.4 mm.

Figure 13 is a schematic view of a wafer support rail tab and rail mounting hole assembly according to the embodiment of the invention shown in Figures 4, 5, 7 and 8 before welding. Wafer supporting rail mounting tab 214 and the respective mounting hole in wall 220 are also precision cut to provide spacings between opposing walls "e" and "f" of preferably less than 0.6 mm and optimally less than 0.4 mm.

Figure 14 is a top view of a lower hemicylinder wall of another embodiment of a wafer boat according to this invention and Figure 15 is a side view of the lower hemicylinder wall shown in Figure 14. In this embodiment, the edge of the end plate has mounting slots (described in greater detail hereinafter with respect to Figure 16), and the ends of the hemicylinder have mounting tabs dimensioned to engage the end plate mounting slots. The lower hemicylinder wall 300 has rows of gas flow openings 302 in the walls, drilled or cut with precise dimensions and locations. End plate mounting tabs 304 are positioned along edge 306 of the

hemicylinder 300, and end plate mounting tabs 308 are positioned along edge 310 of the hemicylinder 300.

Rows of substantially circular rail mounting holes 312, 314, 316 and 318 are provided in the hemicylinder wall 300. The rows of semicircular arcs 320 in the upper edges 322 and 324 of hemicylinder 300, together with opposed arcs in the upper hemicylinder (described in conjunction with Figures 9 and 10 above), form additional circular gas flow passageways.

Positioning notches 326 and 328 are positioned at the ends of the edge 322, and positioning notches 330 and 332 are positioned at the ends of the edge 324 to receive corresponding positioning tabs in the upper hemicylinder. These notches are precision cut to engage and index the hemicylinders in a precise relationship.

Figure 16 is a front view of an end closure plate suitable for the embodiment of the lower hemicylinder wall shown in Figure 14. The end closure plate 340 is precision cut from quartz plate. It has a top edge 342 which abuts a corresponding straight edge of an end plate for the upper hemicylinder element (shown in Figure 11). Mounting slots 344, 346 and 348 are precision cut to engage corresponding, respective mounting tabs 304 or 308 of the hemicylinder 300 shown in Figures 14 and 15. Optional gas flow passageways 350 can be provided for use in processes where gas diffusion through end plate openings is required for optimum coating precision. Edges 352 and 354 are precision cut to conform to and engage the inner surface of the hemicylinder 300. The bottom edge 356 is flattened to conform to the flattened bottom of the hemicylinder surface, which in turn, conforms to the flat index edge of the semiconductor wafer.

In the embodiments shown hereinabove, various combinations of the tabs and slots and tabs and holes (square and round) have been described. Alternative combinations and permutations will readily occur to a person skilled in the art and are intended to be included within the scope of this invention.

Figure 17 is a schematic view of a wafer support rail tab and rail mounting hole assembly according to the embodiment of the invention with the lower hemicylinder shown in Figures 14 and 15 before welding. The wafer supporting rail mounting tabs 220 are rectangular in cross-section, and the mounting holes 314 are circular in cross-section. Both the tab 220 and holes 314 are preferably precision laser-cut in the hemicylinder wall. The distance between the corner edges of the tab 220 and the adjacent wall surface of the hole 314, "g", is preferably less than 0.6 mm and optimally less than 0.4 mm. In this embodiment of rail tab and hemicylinder hole assembly, the round rail mounting holes are provided in the lower hemicylinder walls, presenting less risk of introducing stress cracks around the mounting holes during the welding operation.

Prior to this invention, it was customary to grind all quartz elements requiring precise dimensions, and the dimensional tolerances achieved were consistent with those available with grinders. However, curved edges could be precisely ground only if the plate could be mounted in a jig permitting grinding of the entire circumference at a constant radius, and end closure plates were thus semicircular elements without tabs. Furthermore, holes distanced from the edge of a quartz element were drilled and hence were circular in cross-section and lacked the precision of laser cut holes. Circular tabs could not be formed with precision and hence precision tab and hole joints were not feasible. Elements were joined by welding opposing flat major edges of the elements.

In the process of this invention, the elements are joined by welding opposing surfaces of precision cut tab and slot, or tab and hole combinations, rather than the major edges of the components. Furthermore, the pieces are formed to exact tolerances, preferably by laser cutting all curved and all tab, slot and hole joint elements. Laser cutting techniques permit cutting the components to tolerances of ± 0.05 mm. With this precision, the distances between opposing surfaces of the tabs and slots and tabs and holes can be preferably maintained at less than 0.6 mm and optimally less than 0.4 mm.

The components are assembled and held in the assembled relationship during welding, and to the extent necessary, with a jig which stabilizes the pieces against movement and fixes the distances between all elements of each piece to the desired precision. The joints are then welded from the exterior of the hemicylinders. Conventional gas flames and quartz welding rods commonly used for quartz welding are suitable, but the gas flame is applied to only the small area of each set of opposed surfaces, quickly fusing the surfaces and filling spaces with quartz. The area of glass fusion is restricted to a small area adjacent to the closely fitting pieces, and heating of the positioning jigs and physical distortion or change of the major elements or their relationship is minimized.

Prior to this invention, the portions of the end plates and hemicylinders adjacent to welds, and portions of the rails adjacent to welds were physically and permanently distorted, uncontrollably altering the dimensions from those originally intended. Correction, if possible, involved reworking the interior surfaces, by grinding for example. Even with reworking, over 50 percent of the wafer boats were not usable because of gross distortions.

After welding is completed, the wafer boat hemicylinders are annealed in an furnace until all stresses have been relieved. The annealing temperature is sufficiently high to effect stress relief but is insufficient to allow permanent dimensional changes.

CLAIMS

1. A kit of quartz wafer boat components comprising a hemicylinder (110) and an end enclosure plate (170), one of the hemicylinder and end closure plate having at least one substantially rectangular end plate mounting slot (114,122-128) in the edge thereof, and the other of the hemicylinder and end closure plate having at least one end plate mounting tab (174-178) with a substantially rectangular cross-section, the end plate mounting tab being positioned to engage said end plate mounting slot.

2. A kit of quartz wafer boat components according to claim 1 wherein the end plate mounting slot and tab are dimensioned to provide a spacing of less than 0.6 mm between opposing surfaces when the tab and slot is engaged.

3. A kit of quartz wafer boat components of claim 1 or claim 2 wherein said end plate mounting slot is on the end of the hemicylinder, and said end plate mounting tab extends radially outward from the end plate.

4. A kit of quartz wafer boat components of claim 1 or claim 2 wherein an end plate mounting slot (344-348) is positioned at the edge of each end plate (340), and an end plate mounting tab (304) extends axially outward from an end of the hemicylinder (300).

5. A kit of quartz wafer boat components comprising a lower wafer boat hemicylinder component (110) having rail mounting holes (146,148,158,160) in the walls thereof and at least one wafer support rail (Figs 7 and 8) having substantially rectangular rail mounting tabs (204,214) positioned for engaging said mounting holes.

6.      A kit of quartz wafer boat components of claim 5 wherein the rail mounting tabs and the rail mounting holes are dimensioned to provide a spacing of less than 0.6 mm between opposing surfaces when the rail mounting tabs are placed in the rail mounting holes.

7.      A kit of quartz wafer boat components according to claim 5 or claim 6 including an end closure plate (170), wherein one of the hemicylinder and end closure plate has a substantially rectangular end plate mounting slot (114,122-128) in the edge thereof, and the other of the hemicylinder and end closure plate has an end plate mounting tab (174-178), the end plate mounting tab having a substantially rectangular cross-section and being positioned to engage said end plate mounting slot.

8.      A kit of quartz wafer boat components according to claim 7 wherein the end plate mounting slot and tab are dimensioned to provide a spacing of less than 0.6 mm between opposing surfaces when the end plate mounting tab and slot are engaged.

9.      A quartz wafer boat kit of any one of the preceding claims wherein said mounting tabs, slots and holes are precision cut with a laser.

10.     A quartz wafer boat assembly comprising a kit of any one of the preceding claims assembled with said mounting tabs, slots and holes engaged.

11.     A quartz wafer boat assembly of claim 10 wherein surfaces of said mounting tab are welded to edges of respective mounting slots and holes.

12.     A lower wafer support rail for a quartz wafer boat having a plurality of wafer positioning means therein, each wafer positioning means comprising a laser-cut V-shaped notch (208), the bottom (216) of which is rounded.

13. A process for manufacturing a high precision wafer boat from quartz comprising assembling a hemicylinder (110), at least one end plate (170) and at least one wafer support rail (Figs 7, 8) into a lower wafer boat assembly, the hemicylinder having rail mounting holes (146,148,158,160), the water support rails having mounting tabs (204,214) dimensioned to engage the rail boat mounting holes during assembly, one of the hemicylinder and an end plate having an end plate mounting tab (174-178) and the other of the hemicylinder and end plate having an end plate mounting hole (114,122-128) positioned to engage the end plate mounting tab during assembly, welding the engaged rail mounting tabs and rail mounting holes into a unitary structure, and welding the engaged end plate tab and end plate slot into a unitary structure, the rail mounting tabs, rail mounting holes, end plate mounting tab and end plate mounting slot having been precision cut by laser.

14. A process of manufacturing a quartz wafer boat having a hemicylinder (110) with slotted, axially extending wafer rails (Figs 7,8) welded thereto comprising

     a) laser cutting a slotted wafer support rail with rail mounting tabs (204,214) having a substantially rectangular cross-section;

     b) laser cutting a plurality of precision rail mounting holes (146,148,158,160) in a hemicylinder;

     c) assembling the slotted wafer support rail and the hemicylinder with the rail mounting tabs engaging the rail mounting holes; and

     d) welding the opposing surfaces of the rail mounting tabs and the rail mounting holes into a unitary structure without raising the unengaged components to a temperature at which the dimensions of the rail and the hemicylinder are changed.

15.    A process of manufacturing a quartz wafer boat having a hemicylinder (110) with semicircular end plates (170) welded thereto comprising

    a) laser cutting a semicircular end plate (170) with substantially rectangular end plate mounting means (174-178) at the edges thereof;

    b) laser cutting a plurality of precision substantially rectangular end plate mounting means (114, 118,122-128,130-136) in the ends of the hemicylinder (110), the end plate mounting means of one of the end plate and hemicylinder including a slot and the end plate mounting means of the other of the end plate and hemicylinder including a tab positioned to engage the slot;

    c) assembling the end plate and the hemicylinder with the end plate mounting tab engaging the end plate mounting slot; and

    d) welding opposing surfaces of the end plate mounting tab and end plate mounting slot into a unitary structure without raising the unengaged components to a temperature at which the dimensions of the end plate and the hemicylinder are changed.

16.    A process of claim 12 for manufacturing a wafer boat comprising a hemicylinder with slotted, axially aligned wafer rails welded thereto comprising

    a) laser cutting a slotted wafer support rail (Figs 7, 8) with rail mounting tabs (204,214) having a substantially rectangular cross-section;

    b) laser cutting a plurality of precision rail mounting holes (146,148,158,160) in a hemicylinder (110);

c) assembling the slotted wafer support rail and the hemicylinder with the rail mounting tabs engaging the rail mounting holes; and

d) welding the opposing surfaces of the rail mounting tabs and the rail mounting holes into a unitary structure without raising the unengaged components to a temperature at which the dimensions of the rail and the hemicylinder are changed.

17. A process of any one of claims 13 to 16 wherein the outer dimensions of said tabs and holes and/or of said tabs and slots is selected to provide a distance between opposing closest surfaces thereof when engaged but unwelded of less than 0.6 mm.

Fig_1

Fig_2

Fig_3

Fig_4

Fig_5

Fig_6

Fig_7

Fig_8

Fig_9

Fig_10

0225111

Fig_11

Fig_16

Fig_14

Fig_15

Fig_12    Fig_13

Fig_17